# EUROPEAN PATENT APPLICATION

(11) **EP 4 492 432 A1**
(43) Date of publication of application: **15.01.2025**
(21) Application number: 23766712.6
(22) Date of filing: 02.03.2023
(51) Int. Cl.: H01L 21/20, H01L 21/365

(54) **GROUP III NITRIDE SEMICONDUCTOR WAFER, AND MANUFACTURING METHOD THEREOF**

(30) Priority: 10.03.2022 JP 2022037420
(71) Applicant: Shin-Etsu Handotai Co., Ltd., Tokyo 100-0004 (JP)
(72) Inventor: KUBONO, Ippei, Annaka-shi, Gunma 379-0196 (JP); HAGIMOTO, Kazunori, Annaka-shi, Gunma 379-0196 (JP)
(74) Representative: Mooser, Sebastian Thomas
(86) International application number: PCT/JP2023/007896
(87) International publication number: WO 2023/171536

(57) **Abstract**

The present invention is a group-III nitride semiconductor wafer including a group-III nitride semiconductor film on a substrate for film formation, in which in a cross-sectional shape of a surface of the substrate for film formation of a chamfered portion of the substrate in a diameter direction, a chamfering angle (θ₁) relative to the surface of the substrate is 21° or more and 23° or less, and on the surface of the substrate in a diameter direction, a chamfering width (X₁) is 500 um or more and 1000 um or less, which is a distance between an outer peripheral end portion of the substrate for film formation and an inner peripheral end portion of the chamfered portion. Thereby, the group-III nitride semiconductor wafer, in which the group-III nitride semiconductor film is provided on the substrate for film formation, and the method for producing the same are provided.

## Description

### TECHNICAL FIELD

The present invention relates to a group-III nitride semiconductor wafer and a method for producing the same.

### BACKGROUND ART

A group-III nitride semiconductor represented by GaN is expected to be the semiconductor material for the next generation, exceeding the limitation of Si as the material. GaN has characteristics of high saturated electron velocity and thus can produce a device capable of high-frequency operation and operable at a higher output due to a large dielectric breakdown electric field. Moreover, weight reduction, miniaturization, and lower electric power consumption can be expected.

In recent years, the demand for an accelerated communication speed represented by 5G and an accompanying higher output has attracted attention toward a GaN HEMT operable at high frequency and high output. Moreover, GaN is used for power device applications.

A MOCVD method is one of the methods of producing a group-III nitride semiconductor. The MOCVD method is widely used because of superiority in enlargement of diameter and mass productivity, capability to perform drastic film control, and ability to form a homogeneous thin-film crystal. A Si substrate, being inexpensive and enlargeable in diameter, is widely used as a substrate for heteroepitaxial forming the group-III nitride semiconductor (e.g., GaN) in the MOCVD method.

When epitaxially grown on the substrate, it is known that a local film-thickening, called a crown, is generated due to abnormal growth of an epitaxial layer at an outer peripheral portion of the substrate, causing problems such as cracks, and various attempts have been made to prevent this.

Patent Document 1 proposes a method to prevent generations of crowns by chamfering an outer peripheral portion of a silicon-based substrate such that a chamfering angle θ is θ_{1, 2} ≤ 16° and by limiting a distance of a perpendicular line between the end portion of a chamfered portion and a surface of the substrate. However, the chamfering angle θ is generally set around 22°, and a change in this value increases the cost due to process changes. Moreover, this change may cause an increase in failures when transitioned to device processes and an increase in cost due to the process changes.

Paragraph 28 in Patent Document 2 discloses a method for physically creating a state in which no epitaxial film is formed on the peripheral portion by epitaxially growing in a state where a peripheral portion of a silicon substrate is enclosed with a ring, thereby preventing the generation of a crown. However, this method reduces an effective area usable as a device.

Patent Document 3 discloses setting a chamfering width so as to have a generating location of an edge crown on a processed chamfering slope. Patent Document 3 discloses that the generating location of the surface crown is generally constant regardless of the sizes of the chamfering angle and the chamfering width, when the chamfering width is set to be wider than the generating position of the crown, the crown will be located on the processed chamfering slope, resulting in a relative crown height relative to the epitaxial main surface being lowered.

### CITATION LIST

### PATENT LITERATURE

Patent Document 1: JP S59-227117 A
Patent Document 2: JP 2013-171898 A
Patent Document 3: JP H07-226349 A

### SUMMARY OF INVENTION

### TECHNICAL PROBLEM

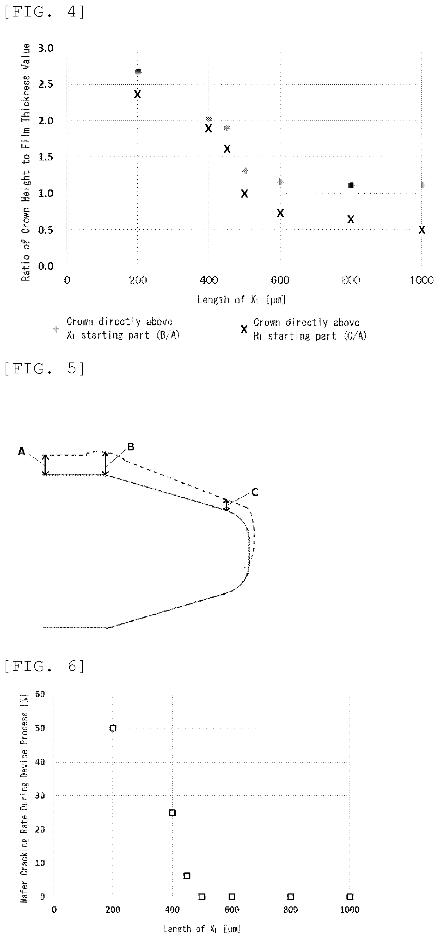

However, the present inventors have studied GaN heteroepitaxial growth and found that a highest position of a crown is in the vicinity of a boundary between an epitaxial layer and the starting part of a chamfered taper (a crown B at the starting part of a chamfering width) regardless of a length of a chamfering width X₁ (FIG. 5), confirming that increasing the width of the chamfering width X₁ has an effect of reducing an absolute height of the crown. Moreover, while Patent Document 3 is about homoepitaxial growth in which a silicon layer is formed on a silicon substrate, in heteroepitaxial growth of the present invention, stress is also applied due to a difference in lattice constant and difference in coefficient of thermal expansion between the substrate and the epitaxial layer, thus the layer is prone to crack, and an effect of the crown is noticeable even when the epitaxial layer is not thick.

In the heteroepitaxially formation of GaN, in addition to being prone to crack due to large stress applied by a difference in lattice constant and difference in coefficient of thermal expansion between the substrate and GaN, when the crown is generated, the stress generated in the vicinity of the crown is also applied and the layer is very prone to crack during device processing and handling thereof. Moreover, when the crown is present, a defocusing problem is also caused in an exposure step of the device process. Although a crown prevention measure is indispensable in forming the GaN heteroepitaxial film for these reasons, no technique has been disclosed until now to suppress the crowns by changing only chamfering width X₁ while chamfering angle θ₁ remains generic 22°±1°.

The present invention is to solve a problem described above, and an object thereof is to provide a group-III nitride semiconductor wafer including a group-III nitride semiconductor film on a substrate for film formation and a method for producing the same.

### SOLUTION TO PROBLEM

To achieve the object, the present invention provides a group-III nitride semiconductor wafer comprising:
a group-III nitride semiconductor film on a substrate for film formation, wherein
in a cross-sectional shape of a surface of the substrate for film formation of a chamfered portion of the substrate in a diameter direction, a chamfering angle (θ₁) relative to the surface of the substrate is 21° or more and 23° or less, and
on the surface of the substrate in a diameter direction, a chamfering width (X₁) is 500 um or more and 1000 um or less, which is a distance between an outer peripheral end portion of the substrate for film formation and an inner peripheral end portion of the chamfered portion.

According to such a group-III nitride semiconductor wafer, the height of a crown can be lowered to an extent that substrate cracking is sufficiently suppressed.

In addition, in the present invention, it is preferred that the group-III nitride semiconductor film contains any one or more of GaN, AlN, or AlGaN.

Such a group-III nitride semiconductor wafer is suitable for high-frequency, high-output devices, and the like that have been required in recent years.

Moreover, in the present invention, it is preferred that the substrate for film formation is a silicon substrate or a substrate in which a surface layer is a silicon layer.

Such a group-III nitride semiconductor wafer can be relatively inexpensive and of high quality.

At this time, it is preferred that an axial orientation in a direction perpendicular to the surface of the silicon substrate or the substrate in which the surface layer is the silicon layer is <111>.

According to such a group-III nitride semiconductor wafer, the group-III nitride semiconductor having a crystal structure of a hexagonal crystal such as GaN can be epitaxially grown on the substrate.

In addition, in the present invention, it is preferred that the group-III nitride semiconductor film has a film thickness of 10 um or less.

Such a group-III nitride semiconductor wafer is preferable because the height of the crown is not elevated.

Moreover, in the present invention, it is preferred that the substrate for film formation has a thickness of 1150 um or less.

Such a group-III nitride semiconductor wafer has sufficient strength and no need to be thickened than necessary.

Moreover, in the present invention, it is preferred that in the cross-sectional shape of the surface of the substrate for film formation of the outer peripheral end portion of the substrate in the diameter direction, a length (T₂) of a portion perpendicular to the surface is 200 um or more.

When T₂ is 200 um or more, the edge portion of the substrate is not extremely thin and thus does not cause chipping and cracking.

In addition, the present invention provides a method for producing a group-III nitride semiconductor wafer in which a group-III nitride semiconductor film is formed on a substrate for film formation to produce a group-III nitride semiconductor wafer, wherein
the substrate for film formation is used as a substrate in which a chamfering angle (θ₁) relative to a surface of the substrate is 21° or more and 23° or less in a cross-sectional shape of the surface of the substrate of a chamfered portion in a diameter direction and a chamfering width (X₁) is 500 um or more and 1000 um or less which is a distance between an outer peripheral end portion of the substrate for film formation and an inner peripheral end portion of the chamfered portion on the surface of the substrate in a diameter direction.

According to such a method for producing the group-III nitride semiconductor wafer, the group-III nitride semiconductor wafer can be produced in which the height of a crown is lowered to an extent that substrate cracking is sufficiently suppressed.

Moreover, in the present invention, it is preferred that the group-III nitride semiconductor film contains any one or more of GaN, AlN, or AlGaN.

According to such a method for producing the group-III nitride semiconductor wafer, the group-III nitride semiconductor wafer can be produced, in which the wafer is suitable for high-frequency, high-output devices, and the like that have been required in recent years.

In addition, in the present invention, it is preferred that the substrate for film formation is a silicon substrate or a substrate in which a surface layer is a silicon layer.

Such a method for producing the group-III nitride semiconductor wafer can produce the group-III nitride semiconductor wafer being relatively inexpensive and of high-quality.

In this case, it is preferred that an axial orientation in a direction perpendicular to the surface of the silicon substrate or the substrate in which the surface layer is the silicon layer is <111>.

According to such a method for the group-III nitride semiconductor wafer, the group-III nitride semiconductor having a crystal structure of a hexagonal crystal such as GaN can be epitaxially grown on the substrate.

Moreover, in the present invention, it is preferred that the group-III nitride semiconductor film has a film thickness of 10 um or less.

According to such a method for producing the group-III nitride semiconductor wafer, the group-III nitride semiconductor wafer can be produced, in which the height of the crown is not elevated.

Moreover, in the present invention, it is preferred that the substrate for film formation has a thickness of 1150 um or less.

According to such a method for producing the group-III nitride semiconductor wafer, the group-III nitride semiconductor wafer having sufficient strength and no need to be thickened than necessary can be produced.

Moreover, in the present invention, it is preferred that in the cross-sectional shape of the surface of the substrate for film formation of the outer peripheral end portion of the substrate in the diameter direction, a length (T₂) of a portion perpendicular to the surface is 200 um or more.

When T₂ is 200 um or more, the edge portion of the substrate is not extremely thin and thus does not cause chipping and cracking.

### ADVANTAGEOUS EFFECTS OF INVENTION

As described above, according to such the inventive group-III nitride semiconductor wafer, by setting a chamfering angle to 21° ≤ θ₁ ≤ 23°, the chamfering width to 500 um ≤ X₁ ≤ 1000 µm in the cross-sectional shape of the substrate surface of the chamfered portion in the diameter direction of the substrate for film formation; the height of the crown can be lowered to the extent that substrate cracking is sufficiently suppressed. In addition, the wafer can be suitable for high-frequency, high-output devices and the like that have been required in recent years.

### BRIEF DESCRIPTION OF DRAWINGS

FIG. 1 is a view illustrating each parameter in a cross-sectional shape of a substrate surface of a chamfered portion in a diameter direction of a substrate for film formation of a group-III nitride semiconductor wafer according to the present invention.
FIG. 2 is a view illustrating a cross-sectional shape of a substrate surface of a chamfered portion in a diameter direction in Example 3.
FIG. 3 is a view illustrating a cross-sectional shape of a substrate surface of a chamfered portion in a diameter direction in Comparative Example 1.
FIG. 4 is a graph showing a ratio of crown height to epitaxial film thickness value in Examples and Comparative Examples.
FIG. 5 is an explanatory view of crown measurement points in FIG. 4.
FIG. 6 is a graph showing a proportion of wafer cracking during a device process in Examples and Comparative Examples.

### DESCRIPTION OF EMBODIMENTS

As described above, it has been desired to develop a group-III nitride semiconductor wafer provided with a group-III nitride semiconductor film on a substrate for film formation and a method for producing such a wafer.

The present inventors have earnestly studied the problem above and thereupon found out that a group-III nitride semiconductor wafer having a chamfering angle (θ₁) of a substrate for film formation of 21° or more and 23° or less, the chamfering width (X₁) of the substrate of 500 um or more and 1000 um or less can lower a height of a crown to the extent that substrate cracking is sufficiently suppressed, and this finding has led to the completion of the present invention.

That is, the present invention is a group-III nitride semiconductor wafer comprising:
a group-III nitride semiconductor film on a substrate for film formation, wherein
in a cross-sectional shape of a surface of the substrate for film formation of a chamfered portion of the substrate in a diameter direction, a chamfering angle (θ₁) relative to the surface of the substrate is 21° or more and 23° or less, and
on the surface of the substrate in a diameter direction, a chamfering width (X₁) is 500 um or more and 1000 um or less, which is a distance between an outer peripheral end portion of the substrate for film formation and an inner peripheral end portion of the chamfered portion.

Furthermore, the present invention provides a method for producing a group-III nitride semiconductor wafer in which a group-III nitride semiconductor film is formed on a substrate for film formation to produce a group-III nitride semiconductor wafer, wherein
the substrate for film formation is used as a substrate in which a chamfering angle (θ₁) relative to a surface of the substrate is 21° or more and 23° or less in a cross-sectional shape of the surface of the substrate of a chamfered portion in a diameter direction and a chamfering width (X₁) is 500 um or more and 1000 um or less which is a distance between an outer peripheral end portion of the substrate for film formation and an inner peripheral end portion of the chamfered portion on the surface of the substrate in a diameter direction.

Hereinafter, the present invention will be described in detail. However, the present invention is not limited thereto.

### [Group-III Nitride Semiconductor Wafer]

The present invention is a group-III nitride semiconductor wafer including, a group-III nitride semiconductor film on a substrate for film formation, in which in a cross-sectional shape of a surface of the substrate for film formation of a chamfered portion of the substrate in a diameter direction, a chamfering angle (θ₁) relative to the surface of the substrate is 21° or more and 23° or less, and on the surface of the substrate in a diameter direction, a chamfering width (X₁) is 500 um or more and 1000 um or less, which is a distance between an outer peripheral end portion of the substrate for film formation and an inner peripheral end portion of the chamfered portion.

According to such a group-III nitride semiconductor wafer, the height of a crown can be lowered to an extent that substrate cracking is sufficiently suppressed.

It is preferred that the group-III nitride semiconductor film contains any one or more of GaN, AlN, or AlGaN. Such a group-III nitride semiconductor film is preferred because such a film is suitable for high-frequency, high-output devices, and the like that have been required in recent years.

In the present invention, the cross-sectional shape of the surface of the substrate of the chamfered portion of the substrate for film formation being used in the diameter direction has a chamfering angle of 21° ≤ θ₁ ≤ 23°, and a chamfering width of 500 um ≤ X₁ ≤ 1000 µm.

At this point, the range of the chamfering angle θ₁ is in a range of 21° or more and 23° or less, which is a typical chamfering angle of the substrate for film formation. When the chamfering angle is outside this range, extra cost increase and yield decrease due to process changes, etc., occurs and it is unpreferable.

When the length of the chamfering width X₁ is 500 um or more and 1000 um or less, the generation of the crown can be suppressed to the height that substrate cracking can be suppressed.

Meanwhile, when the length of the chamfering width X₁ is less than 500 µm, a sufficient effect prevention of wafer cracking by reducing the crown height cannot be obtained. Alternatively, the length of the chamfering width X₁ exceeding 1000 um is unpreferable, as an effective area on the wafer surface becomes smaller, and the device yield is lowered.

A superlattice Buffer layer can be provided directly above the substrate for film formation. The superlattice Buffer layer can have an AlN layer directly above the substrate for film formation, an AlGaN layer on top of that, and two or three of the AlN layer, the AlGaN layer, or the GaN layer in steps of a few nm further on top of that. The structure of the superlattice Buffer layer is not limited to this structure but also may have a case where no AlGaN is present or a case where the AlN layer is further provided on the AlGaN layer. Moreover, a case in which the structure has a plurality of AlGaN layers with varied Al compositions may be present. The total thickness of the group-III nitride semiconductor film (epitaxial layer) is not particularly limited as is changed depending on an application; 10 um or less is preferable as the thicker the film, the higher the crown height tends to be.

A front surface side of the epitaxial layer can be provided with a device layer. The device layer can have a structure provided with a highly crystalline layer where two-dimensional electron gas is generated (channel layer), a layer for generating two-dimensional electron gas (barrier layer), and a cap layer on the topmost surface layer. The AlGaN having the Al composition of about 20% can be used for the barrier layer, but InGaN, for example, can be used, and not limited thereto. The cap layer can be, for example, the GaN layer or the SiN layer but not limited thereto. In addition, the thicknesses of these device layers and the Al compositions of these barrier layers are changed depending on the design of the device.

In the present invention, the substrate for film formation is preferably a silicon substrate or a substrate in which a surface layer is a silicon layer. Such a substrate for film formation can be relatively inexpensive and of high quality, and thus preferred. At this time, it is preferred that an axial orientation in a direction perpendicular to the surface of the silicon substrate or the substrate in which the surface layer is the silicon layer is <111>. According to such an axial orientation, it is preferred because the group-III nitride semiconductor having a crystal structure of a hexagonal crystal such as GaN can be epitaxially grown on the substrate.

The group-III nitride semiconductor film preferably has a film thickness of 10 um or less. Such a film thickness is preferable because the height of the crown is not elevated. The lower limit of the film thickness of the group-III nitride semiconductor film is not particularly limited but, for example, can be 1 um or more.

In addition, it is preferred that the substrate for film formation has a thickness of 1150 um or less. When the substrate for film formation has such a thickness, the substrate has sufficient strength and no need to be thickened more than necessary; therefore, it is preferable. The lower limit of the thickness of the substrate for film formation is not particularly limited but can be, for example, 620 um or more.

Moreover, it is preferred that in the cross-sectional shape of the surface of the substrate for film formation of the outer peripheral end portion of the substrate in the diameter direction, a length (T₂) of a portion perpendicular to the surface is 200 um or more. When T₂ has such a length, it is preferred that the edge portion of the substrate is not extremely thin and thus does not cause chipping and cracking. The upper limit of T₂ is not particularly limited but can be, for example, 750 um or less.

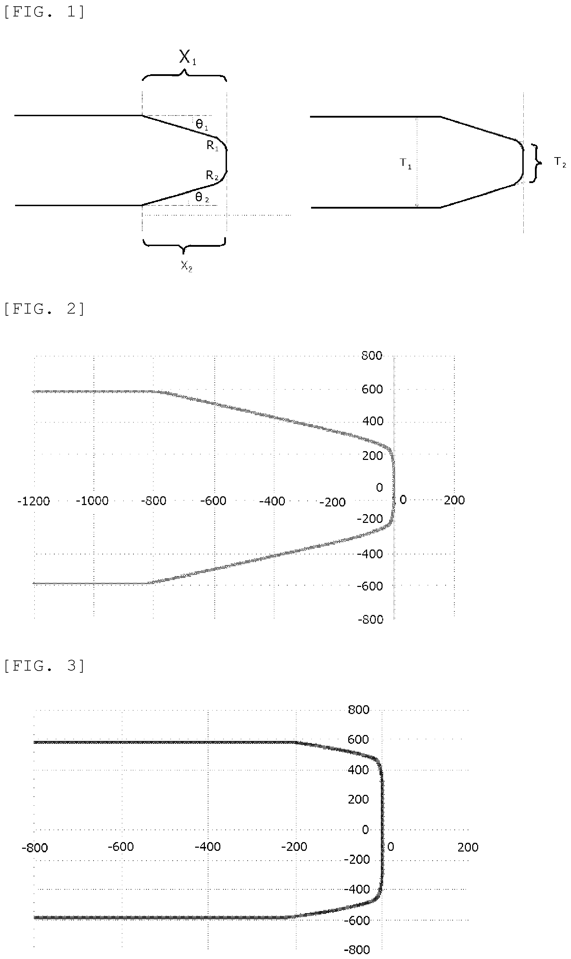

By the use of FIG. 1, each of the parameters of the cross-sectional shape of the surface of the substrate of the chamfered portion in the diameter direction is described. The substrate for film formation used in the present invention has the chamfering angle of θ₁ relative to the substrate surface, the chamfering width of X₁ being the distance between the outer peripheral end portion of the substrate for film formation and the inner peripheral end portion of the chamfered portion on the substrate surface in the diameter direction, and a curved surface having a curvature radius of R₁ between the outer peripheral end portion and a chamfered surface on the front surface side, in the cross-sectional shape of the surface of the substrate of the chamfered portion in the diameter direction.

In addition to these, in the cross-sectional shape of the surface of the substrate of the chamfered portion in the diameter direction, a chamfering angle relative to a substrate back surface is defined as θ₂, a chamfering width being a distance between an outer peripheral end portion of the substrate for film formation and an inner peripheral end portion of the chamfered portion on the substrate back surface in the diameter direction is defined as X₂, and the outer peripheral end portion and the chamfered surface on the back surface side has a curved surface having a curvature radius of R₂.

Furthermore, the thickness of the substrate for film formation is defined as T₁, and the length of a portion perpendicular to the surface in the cross-sectional shape of the surface of the substrate for film formation of the outer peripheral end portion of the substrate in the diameter direction is defined as T₂.

### [Method for Producing Group-III Nitride Semiconductor Wafer]

The present invention is a method for producing a group-III nitride semiconductor wafer in which a group-III nitride semiconductor film is formed on a substrate for film formation to produce a group-III nitride semiconductor wafer, in which the substrate for film formation is used as a substrate in which a chamfering angle (θ₁) relative to a surface of the substrate is 21° or more and 23° or less in a cross-sectional shape of the surface of the substrate of a chamfered portion in a diameter direction and a chamfering width (X₁) is 500 um or more and 1000 um or less which is a distance between an outer peripheral end portion of the substrate for film formation and an inner peripheral end portion of the chamfered portion on the surface of the substrate in a diameter direction.

According to such a method for producing the group-III nitride semiconductor wafer, the group-III nitride semiconductor wafer can be produced in which the height of a crown is lowered to an extent that substrate cracking is sufficiently suppressed.

Moreover, in the present invention, epitaxial growth of the group-III nitride semiconductor film containing any one or more of GaN, AlN, or AlGaN can be performed on the substrate for film formation, for example, in an MOCVD reaction furnace. In this case, the substrate for film formation is not particularly limited, and the same effects can be obtained by using any substrates for film formation, such as a SiC substrate or a bonded substrate. According to such a method for producing the group-III nitride semiconductor wafer, the group-III nitride semiconductor wafer can be produced, in which the wafer is suitable for high-frequency, high-output devices, and the like that have been required in recent years.

In the present invention, the cross-sectional shape of the surface of the substrate of the chamfered portion in the diameter direction of the substrate for film formation being used is produced to make a chamfering angle of 21° ≤ θ1 ≤ 23°, a chamfering width of 500 um ≤ X₁ ≤ 1000 um.

At this point, the production is performed without changing the range of the chamfering angle θ₁, being 21° or more and 23° or less, which is a typical chamfering angle of the substrate for film formation. When the chamfering angle is outside this range, extra cost increase and yield decrease due to process changes, etc., occurs, and it is unpreferable.

By producing so as to make the length of the chamfering width X₁ 500 um or more and 1000 um or less, the generation of the crown can be suppressed to the height that substrate cracking is suppressed.

Meanwhile, when the length of the chamfering width X₁ is less than 500 µm, the sufficient effect prevention of wafer cracking by reducing the crown height cannot be obtained. The length of the chamfering width X₁ exceeding 1000 um is unpreferable, as a flat region where the device can be fabricated becomes smaller, and the device yield is lowered.

When epitaxially grown, TMAl can be used as an Al source, TMGa as a Ga source, and NH₃ as an N source. In addition, a carrier gas can be N₂, H₂, or both, and a process temperature can be about 900 to 1250°C.

It is preferred that the substrate for film formation is a silicon substrate or a substrate in which a surface layer is a silicon layer. By using such a substrate for film formation, the group-III nitride semiconductor wafer, which is relatively inexpensive and of high quality, can be produced. In this case, it is preferred that an axial orientation in a direction perpendicular to the surface of the silicon substrate or the substrate in which the surface layer is the silicon layer is <111>. By making such an axial orientation, the group-III nitride semiconductor having the crystal structure of the hexagonal crystal such as GaN can be epitaxially grown on the substrate.

It is preferred that the group-III nitride semiconductor film has a film thickness of 10 um or less. By making such a film thickness, the group-III nitride semiconductor wafer can be produced, in which the height of the crown is not elevated.

It is preferred that the substrate for film formation has a thickness of 1150 um or less. By making such a thickness of the substrate for film formation, the group-III nitride semiconductor wafer having sufficient strength and no need to be thickened than necessary can be produced.

It is preferred that in the cross-sectional shape of the surface of the substrate for film formation of the outer peripheral end portion of the substrate in the diameter direction, a length (T₂) of a portion perpendicular to the surface is 200 um or more. By making T₂ such a thickness, the edge portion of the substrate is not extremely thin and thus does not cause chipping and cracking.

### EXAMPLES

Hereinafter, the present invention will be specifically described with reference to Examples and Comparative Examples. However, the present invention is not limited thereto.

### [Example 1]

A group-III nitride semiconductor film composed of AlN, AlGaN, GaN, and the like was epitaxially grown on a silicon substrate in an MOCVD reaction furnace.

The silicon substrate, in which a thickness thereof is 1000 µm, an axial orientation in a direction perpendicular to a surface is <111>, and a cross-sectional shape of the surface of the substrate of a chamfered portion in a diameter direction has a chamfering angle θ₁ = 22° and a chamfering width X₁ = 500 µm, was used.

The AlN layer was formed directly above the silicon substrate, and the AlGaN layer was formed thereon, followed by alternating the AlN layers and the AlGaN layers further on to form a superlattice Buffer layer. A C-doped GaN layer was formed directly above the Buffer layer, and a C non-doped GaN layer and a device layer were provided thereon.

A total thickness of the epitaxial layer was designed to be 10 um.

When epitaxially grown, TMAl was used as an Al source, TMGa as a Ga source, and NH₃ as an N source. In addition, a carrier gas was N₂, H₂, or both, and a process temperature was about 900 to 1250°C.

After forming the epitaxial layer, the substrate was cleaved, and analysis was performed from a cross-sectional direction by an electron microscope such as an SEM to determine the height of a crown and a film thickness of the epitaxial layer at a position sufficiently far from the crown in a direction towards the center of the wafer (a point separated 2 mm or more), and a ratio therebetween was calculated.

Moreover, a rate of crack during a device process was calculated.

### [Examples 2, 3, and 4]

Lengths of a chamfering width X₁ were set to 600 µm, 800 µm, and 1000 µm, in a cross-sectional shape of a surface of a substrate of a chamfered portion in a diameter direction in a silicon substrate provided in Example 1. A condition for a chamfering angle θ₁ was 22° as in Example 1.

Subsequently, film formations were performed on each silicon substrate in an MOCVD reaction furnace under the same epitaxial growth condition as in Example 1.

### [Comparative Examples 1, 2, and 3]

Lengths of a chamfering width X₁ were set to 200 µm, 400 µm, and 450 µm, in a cross-sectional shape of a surface of a substrate of a chamfered portion in a diameter direction in a silicon substrate provided in Example 1. A condition for a chamfering angle θ₁ was 22° as in Example 1.

Subsequently, film formations were performed on each silicon substrate in an MOCVD reaction furnace under the same epitaxial growth condition as in Example 1.

The cross-sectional shape of the surface of the substrate of the chamfered portion in the diameter direction in Example 3 is shown in FIG. 2, and the cross-sectional shape of the surface of the substrate of the chamfered portion in the diameter direction in Comparative Example 1 is shown in FIG. 3.

Ratios of crown heights to film thickness values of the epitaxial layers in Examples and Comparative Examples are shown in FIG. 4. As shown in FIG. 4, the inventive group-III nitride semiconductor wafer has lower ratios of crown heights to film thickness values of the epitaxial layers than those in Comparative Examples.

FIG. 5 shows crown measurement points in FIG. 4. The film thickness A of the epitaxial layer, crown B at the chamfering width starting part, and crown C at a curvature radius starting part are included.

A proportion of wafer cracking during a device process in Examples and Comparative Examples is shown in FIG. 6. As shown in FIG. 6, the inventive group-III nitride semiconductor wafer does not cause the wafer cracking during the device process.

Moreover, when the length of the chamfering width X₁ exceeds 1000 µm, an effective area on the wafer is decreased, resulting in a lower device yield.

It should be noted that the present invention is not limited to the above-described embodiments. The embodiments are just examples, and any examples that have substantially the same feature and demonstrate the same functions and effects as those in the technical concept disclosed in claims of the present invention are included in the technical scope of the present invention.

## Claims

1. A group-III nitride semiconductor wafer comprising:
a group-III nitride semiconductor film on a substrate for film formation, wherein
in a cross-sectional shape of a surface of the substrate for film formation of a chamfered portion of the substrate in a diameter direction, a chamfering angle (θ₁) relative to the surface of the substrate is 21° or more and 23° or less, and
on the surface of the substrate in a diameter direction, a chamfering width (X₁) is 500 um or more and 1000 um or less, which is a distance between an outer peripheral end portion of the substrate for film formation and an inner peripheral end portion of the chamfered portion.

2. The group-III nitride semiconductor wafer according to claim 1, wherein
the group-III nitride semiconductor film contains any one or more of GaN, AlN, or AlGaN.

3. The group-III nitride semiconductor wafer according to claim 1 or 2, wherein,
the substrate for film formation is a silicon substrate or a substrate in which a surface layer is a silicon layer.

4. The group-III nitride semiconductor wafer according to the claim 3, wherein
an axial orientation in a direction perpendicular to the surface of the silicon substrate or the substrate in which the surface layer is the silicon layer is <111>.

5. The group-III nitride semiconductor wafer according to any one of claims 1 to 4, wherein
the group-III nitride semiconductor film has a film thickness of 10 um or less.

6. The group-III nitride semiconductor wafer according to any one of claims 1 to 5, wherein
the substrate for film formation has a thickness of 1150 um or less.

7. The group-III nitride semiconductor wafer according to any one of claims 1 to 6, wherein
in the cross-sectional shape of the surface of the substrate for film formation of the outer peripheral end portion of the substrate in the diameter direction, a length (T₂) of a portion perpendicular to the surface is 200 um or more.

8. A method for producing a group-III nitride semiconductor wafer in which a group-III nitride semiconductor film is formed on a substrate for film formation to produce a group-III nitride semiconductor wafer, wherein
the substrate for film formation is used as a substrate in which a chamfering angle (θ₁) relative to a surface of the substrate is 21° or more and 23° or less in a cross-sectional shape of the surface of the substrate of a chamfered portion in a diameter direction and a chamfering width (X₁) is 500 um or more and 1000 um or less which is a distance between an outer peripheral end portion of the substrate for film formation and an inner peripheral end portion of the chamfered portion on the surface of the substrate in a diameter direction.

9. The method for producing the group-III nitride semiconductor wafer according to claim 8, wherein
the group-III nitride semiconductor film contains any one or more of GaN, AlN, or AlGaN.

10. The method for producing the group-III nitride semiconductor wafer according to claim 8 or 9, wherein
the substrate for film formation is a silicon substrate or a substrate in which a surface layer is a silicon layer.

11. The method for producing the group-III nitride semiconductor wafer according to claim 10, wherein
an axial orientation in a direction perpendicular to the surface of the silicon substrate or the substrate in which the surface layer is the silicon layer is <111>.

12. The method for producing the group-III nitride semiconductor wafer according to any one of claims 8 to 11, wherein
the group-III nitride semiconductor film has a film thickness of 10 um or less.

13. The method for producing the group-III nitride semiconductor wafer according to any one of claims 8 to 12, wherein
the substrate for film formation has a thickness of 1150 um or less.

14. The method for producing the group-III nitride semiconductor wafer according to any one of claims 8 to 13, wherein
in the cross-sectional shape of the surface of the substrate for film formation of the outer peripheral end portion of the substrate in the diameter direction, a length (T₂) of a portion perpendicular to the surface is 200 um or more.
